(19)

Europäisches
Patentamt

European
Patent Office

Office européen
des brevets

(11) **EP 1 870 490 A2**

(12) **EUROPEAN PATENT APPLICATION**

(43) Date of publication:
26.12.2007 Bulletin 2007/52

(51) Int Cl.:
*C23C 16/448* (2006.01)        *C23C 16/52* (2006.01)
*G05D 7/00* (2006.01)

(21) Application number: 07011619.9

(22) Date of filing: 13.06.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: 19.06.2006 JP 2006168890
05.12.2006 JP 2006328552
06.03.2007 JP 2007056248

(71) Applicants:
• **Sumitomo Electric Industries, Ltd.**
**Osaka-shi,**
**Osaka 541-0041 (JP)**
• **SOKEN Industries**
**Saitama 350-0833 (JP)**

(72) Inventors:
• **Ueno, Masaki**
**Itami-shi**
**Hyogo 664-0016 (JP)**
• **Ueda, Toshio**
**Itami-shi**
**Hyogo 664-0016 (JP)**

• **Nakamura, Takao**
**Itami-shi**
**Hyogo 664-0016 (JP)**
• **Ishikawa, Koichi**
**Yokohama-shi**
**Kanagawa 222-0033 (JP)**
• **Takahasi, Ken**
**Kawagoe-shi**
**Saitama 350-0833 (JP)**
• **Yasaku, Osamu**
**Kawagoe-shi**
**Saitama 350-0833 (JP)**
• **Ujiie, Kazuo**
**Kawagoe-shi**
**Saitama 350-0833 (JP)**
• **Takemoto, Kikurou**
**Kawagoe-shi**
**Saitama 350-0833 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Evaporator for CVD and gas flow rate regulator.**

(57)     A metal-organic vaporizing and feeding apparatus includes: a retention vessel (1) for retaining a metal-organic material (13); a bubbling gas feeding path (3) connected to the retention vessel (1), for feeding bubbling gas to the metal-organic material (13); a metal-organic gas feeding path (5) connected to the retention vessel (1), for feeding metal-organic gas generated in the retention vessel (1) and dilution gas to a deposition chamber; a dilution gas feeding path (7) connected to the metal-organic gas feeding path (5), for feeding the dilution gas to the metal-organic gas feeding path (5); a flow rate regulator (9) provided in the bubbling gas feeding path (3), for regulating flow rate of the bubbling gas; a pressure regulator (11) for regulating pressure of the dilution gas; and a sonic nozzle (S) disposed in the metal-organic gas feeding path (5) on a downstream side of a connecting position between the metal-organic gas feeding path (5) and the dilution gas feeding path (7).

FIG.1

EP 1 870 490 A2

**Description**

BACKGROUND OF THE INVENTION

Field of the Invention

The present invention relates to metal-organic vaporizing and feeding apparatuses, metal-organic chemical vapor deposition apparatuses, metal-organic chemical vapor deposition methods, gas flow rate regulators, semiconductor manufacturing apparatuses, and semiconductor manufacturing methods, and more specifically, to a metal-organic vaporizing and feeding apparatus, a metal-organic chemical vapor deposition apparatus, a metal-organic chemical vapor deposition method, a gas flow rate regulator, a semiconductor manufacturing apparatus, and a semiconductor manufacturing method which are used for deposition of a nitride compound semiconductor.

Description of the Background Art

The Metal-Organic Chemical Vapor Deposition (MOCVD) method is one of representative vapor phase deposition methods, in which vaporized metal-organic is thermally decomposed on a surface of a substrate and a deposition film is formed thereon. This method is widely used as a deposition technique in production of a semiconductor device because it enables control of film thickness and composition of the deposition film, and provides excellent productivity.

A MOCVD apparatus used for the MOCVD method has a chamber, a susceptor disposed in the chamber, and a metal-organic vaporizing and feeding apparatus for vaporizing a metal-organic material and causing it to flow on the surface of the substrate. In the MOCVD apparatus, deposition is carried out by placing a substrate on a susceptor, heating the substrate to an appropriate temperature while appropriately controlling pressure in the chamber, and feeding metal-organic gas on the surface of the substrate using a metal-organic vaporizing and feeding apparatus. Here, in order to uniformize the condition of a film to be deposited, the flow rate of metal-organic gas to be fed to the surface of the substrate should be usually kept constant. In the MOCVD apparatus, various metal-organic vaporizing and feeding apparatuses have been proposed for keeping the flow rate of metal-organic gas constant.

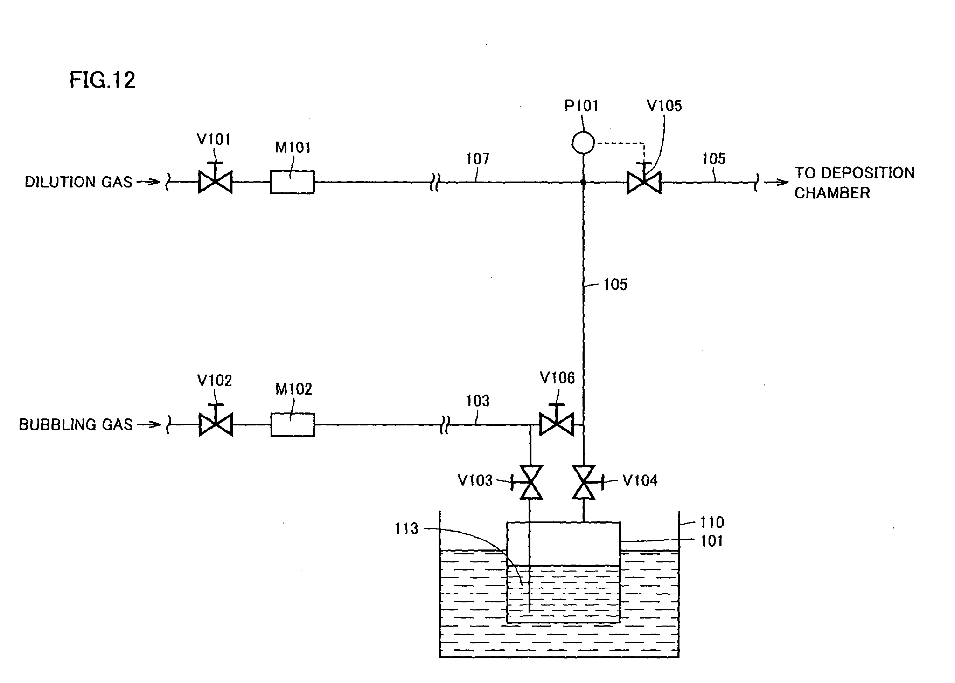

Fig. 12 is a view schematically showing the makeup of a conventional metal-organic vaporizing and feeding apparatus. Referring to Fig. 12, a conventional metal-organic vaporizing and feeding apparatus has a retention vessel 101, a bubbling gas feeding path 103, a metal-organic gas feeding path 105, a dilution gas feeding path 107, a thermostat bath 110, valves V101 to V106, mass flow controllers M101 and M102, and a manometer P101.

Inside thermostat bath 110, retention vessel 101 is disposed, and inside retention vessel 101, liquid of a metal-organic material 113 is retained, and on the upstream side of retention vessel 101, bubbling gas feeding path 103 is connected. Bubbling gas feeding path 103 extends to reach inside metal-organic material 113. Bubbling gas feeding path 103 is provided with valve V102, a mass flow controller M102, and valve V103 in this order from upstream side.

On the downstream side of retention vessel 101, metal-organic gas feeding path 105 is connected. Metal-organic gas feeding path 105 is connected at a position where it does not come into contact with liquid metal-organic material 113. Metal-organic gas feeding path 105 is provided with valve V104, manometer P101, and valve V105 (pressure controlling valve) in this order from upstream side. Manometer P101 and valve V105 are electrically connected. Metal-organic gas feeding path 105 is connected on its downstream side with a deposition chamber (not illustrated).

Metal-organic gas feeding path 105 is connected with dilution gas feeding path 107. Dilution gas feeding path 107 is connected to metal-organic gas feeding path 105 at a position where manometer P101 is provided. Dilution gas feeding path 107 is provided with valve V101 and mass flow controller M101 in this order from upstream side. Between bubbling gas feeding path 103 and metal-organic gas feeding path 105, valve (bypass valve) V106 is provided.

In a conventional metal-organic vaporizing and feeding apparatus, metal-organic gas is fed to a deposition chamber in the following manner. First, by opening valve V102, bubbling gas is fed to bubbling gas feeding path 103. Bubbling gas is fed into retention vessel 101 by closing valve V106 and opening valve V103, while its mass flow rate is controlled by mass flow controller M102. Liquid temperature of metal-organic material 113 is kept constant by thermostat bath 110, and thus vapor pressure is also kept constant. As bubbling gas is fed into retention vessel 101, an amount of metal-organic gas corresponding to the flow rate of bubbling gas is generated from metal-organic material 113 by bubbling, and by opening valve V 104, the generated metal-organic gas and part of bubbling gas are fed into metal-organic gas feeding path 105. On the other hand, by opening valve V101, dilution gas is fed to dilution gas feeding path 107. Dilution gas is fed into metal-organic gas feeding path 105 and mixed with metal-organic gas and bubbling gas, while mass flow rate of dilution gas is controlled by mass flow controller M101. Total pressure of mixed gas of metal-organic gas, dilution gas and bubbling gas is measured by manometer P 101, and valve V105 is regulated based on a value of manometer P101. As a result, metal-organic gas is fed to a deposition chamber at appropriate flow rate and pressure. Since total pressure of mixed gas is controlled by manometer P101 and valve V105, concentration of metal-organic gas in mixed gas is constant.

Structures which are similar to that of the aforementioned conventional metal-organic vaporizing and feeding apparatus are disclosed, for example, in Japanese Patent Laying-Open No. 2002-313731. In Japanese Patent Laying-Open No. 2002-313731, metal-organic material is retained in a metal-organic material gas feeding source, and on the upstream side of the metal-organic material gas feeding source, a feed-in line for feeding $H_2$ gas into the metal-organic material gas feeding source is connected. The feed-in line is provided with a valve and a mass flow controller. On the downstream side of the metal-organic material gas feeding source, a feed-in line for feeding metal-organic material gas into a reactor is connected. The feed-in line is provided with a manometer and a valve. The manometer and the valve are electrically connected. Also in the structure of Japanese Patent Laying-Open No. 2002-313731, a mass flow controller is used for controlling flow rate of each of dilution gas and metal-organic gas.

A mass flow controller has complex makeup because it has an electric circuit for calculating flow rate of gas inside a flow path from flow rate passing through a bypass line and for controlling flow rate based on the calculation result, a control valve for regulating flow rate and so on. A conventional metal-organic vaporizing and feeding apparatus requires at least two mass flow controllers: mass flow controller M102 for controlling flow rate of metal-organic gas, and mass flow controller M101 for controlling flow rate of bubbling gas (dilution gas). Therefore, the conventional metal-organic vaporizing and feeding apparatus involves the problem of complexity of apparatus. Further, since the apparatus is complex, production costs for the metal-organic vaporizing and feeding apparatus increase, and costs for deposition by the MOCVD method increase.

SUMMARY OF THE INVENTION

It is an object of the present invention to provide a metal-organic vaporizing and feeding apparatus, a metal-organic chemical vapor deposition apparatus, a metal-organic chemical vapor deposition method, a gas flow rate regulator, a semiconductor manufacturing apparatus, and a semiconductor manufacturing method capable of simplifying the apparatus.

A metal-organic vaporizing and feeding apparatus of the present invention includes a vessel for retaining a metal-organic material; a bubbling gas feeding path connected to the vessel, for feeding bubbling gas to the metal-organic material; a metal-organic gas feeding path connected to the vessel, for feeding metal-organic gas generated in the vessel and dilution gas for diluting the metal-organic gas to a deposition chamber; a dilution gas feeding path connected to the metal-organic gas feeding path, for feeding the dilution gas to the metal-organic gas feeding path; a flow rate regulator provided in the bubbling gas feeding path, for regulating flow rate of the bubbling gas; a pressure regulator for regulating pressure of the dilution gas; and a restrictor disposed in the metal-organic gas feeding path at the position on the downstream side of a connecting position between the metal-organic gas feeding path and the dilution gas feeding path. The restrictor is capable of regulating flow rate of gas passing through with upstream gas pressure.

According to the metal-organic vaporizing and feeding apparatus of the present invention, gas pressure in the metal-organic gas feeding path is substantially regulated by the pressure regulator, and flow rate of gas to be fed to the deposition chamber is regulated by gas pressure in the metal-organic gas feeding path. Therefore, it is possible to regulate flow rate of the metal-organic gas to be fed to the deposition chamber by the flow rate regulator and the pressure regulator. As a result, a mass flow controller for controlling flow rate of dilution gas is no longer needed and thus the apparatus can be simplified.

In the above metal-organic vaporizing and feeding apparatus, preferably, the flow rate regulator has an element for bubbling gas capable of regulating flow rate of gas passing through with upstream gas pressure and downstream gas pressure, and a bubbling gas pressure regulator disposed on the upstream side of the element for bubbling gas, for regulating pressure in the bubbling gas feeding path.

As a result, it is possible to regulate flow rate of bubbling gas by regulating pressure by bubbling gas pressure regulator. Therefore, a mass flow controller for controlling flow rate of bubbling gas is no longer needed, and the apparatus can be further simplified. In addition, since pressure of bubbling gas can be regulated by the bubbling gas pressure regulator, even when pressure of bubbling gas on the upstream side of the flow rate regulator rapidly changes, the influence of the change exerted on the downstream side can be prevented.

In the above metal-organic vaporizing and feeding apparatus, preferably, the metal-organic gas feeding path has a first feeding path and a second feeding path, the restrictor has a first restrictor disposed in the first feeding path and a second restrictor disposed in the second feeding path, and the first feeding path and the second feeding path are connected on the downstream side of the connecting position and on the downstream side of the first restrictor and the second restrictor. The metal-organic vaporizing and feeding apparatus further includes: a first switcher for switching a kind of the bubbling gas between first bubbling gas and second bubbling gas; and a second switcher for switching a flow path of the metal-organic gas and the dilution gas between the first feeding path and the second feeding path.

As a result, the restrictor can be selected from the first restrictor and the second restrictor depending on the kind of the bubbling gas. As a result, it is possible to prevent the characteristic of flow rate of the gas fed into the deposition chamber from changing with the change of bubbling gas to be used.

In the above metal-organic vaporizing and feeding apparatus, preferably, the first restrictor and the second restrictor are so configured that flow rate of gas passing through the first restrictor when the bubbling gas feeding path is fed with the first bubbling gas and the flow path of the metal-organic gas is switched to the first feeding path and when gas pressure on the upstream side of the first restrictor has a predetermined value, is equal to flow rate of gas passing through the second restrictor when the bubbling gas feeding path is fed with the second bubbling gas, and the flow path of the metal-organic gas is switched to the second feeding path and when gas pressure on the upstream side of the second restrictor has the predetermined value.

As a result, even when the bubbling gas for use is changed from the first bubbling gas to the second bubbling gas, the flow rate of gas to be fed into the deposition chamber can be equalized.

In the above metal-organic vaporizing and feeding apparatus, preferably, there is further included a dilution gas flow rate measuring part disposed in the dilution gas feeding path, for measuring flow rate of the dilution gas.

As a result, when the kind of bubbling gas is switched, whether or not the interior of the vessel is replaced by the bubbling gas after switching can be determined by flow rate of dilution gas, so that it is possible to reduce the time required for pre-bubbling.

In the above metal-organic vaporizing and feeding apparatus, preferably, the dilution gas flow rate measuring part has an element for dilution gas capable of regulating flow rate of gas passing through with upstream gas pressure and downstream gas pressure, a manometer for dilution gas for measuring pressure on the upstream side of the element for dilution gas, and a thermometer for measuring temperature of the element for dilution gas.

As a result, it is possible to calculate flow rate of gas passing through the element for dilution gas from a measurement of the manometer for dilution gas.

A MOCVD apparatus of the present invention includes the above metal-organic vaporizing and feeding apparatus; a gas feeding path for feeding other gas used for deposition to the deposition chamber; and the deposition chamber for conducting deposition using the metal-organic gas and the other gas. As a result, it is possible to simplify the MOCVD apparatus. In addition, deposition can be conducted using plural kinds of material gases.

A metal-organic chemical vapor deposition method of the present invention includes: a flow rate regulating step of feeding bubbling gas to a metal-organic material while regulating flow rate of the bubbling gas; a pressure regulating step of regulating pressure of dilution gas; a mixing step of mixing metal-organic gas generated from the metal-organic material with the dilution gas after the flow rate regulating step and the pressure regulating step to obtain mixed gas; and a depositing step of feeding the mixed gas to a deposition chamber through a restrictor after the mixing step to conduct deposition. The restrictor is capable of regulating flow rate of gas passing through with upstream gas pressure.

According to the metal-organic chemical vapor deposition method of the present invention, pressure of mixed gas of metal-organic gas and dilution gas is substantially regulated by the pressure regulating step, and flow rate of gas fed to the deposition chamber is regulated by the pressure of mixed gas. Accordingly, it is possible to regulate flow rate of the metal-organic gas to be fed into the deposition chamber by the flow rate regulating step and the pressure regulating step. As a result, it is no longer necessary to use a mass flow controller for controlling flow rate of dilution gas and the apparatus can be simplified.

In the above metal-organic chemical vapor deposition method, preferably, the restrictor has a first restrictor and a second restrictor, and the depositing step includes a switching step of switching the restrictor allowing the mixed gas to pass through from the first restrictor to the second restrictor depending on a kind of the dilution gas or the bubbling gas.

As a result, the restrictor can be selected from the first restrictor and the second restrictor depending on the kind of the bubbling gas. As a result, it is possible to prevent the characteristic of flow rate of the gas fed into the deposition chamber from changing with the change of bubbling gas to be used.

In the above metal-organic chemical vapor deposition method, preferably, there is further included a measuring step of measuring flow rate of the dilution gas. The depositing step is conducted after the flow rate of the dilution gas is converged to a predetermined value in the measuring step.

As a result, when the kind of bubbling gas is switched, whether or not the interior of the vessel is replaced by the bubbling gas after switching can be determined by flow rate of dilution gas, so that it is possible to reduce the time required for pre-bubbling.

In the above metal-organic chemical vapor deposition method, preferably, a compound semiconductor is deposited in the depositing step, and more preferably, the compound semiconductor is made of $Al_xGa_yIn_{1-x-y}N$ ($0 \leq x \leq 1$, $0 \leq y \leq 1$, $0 \leq x+y \leq 1$).

Since plural kinds of material gases are used in depositing compound semiconductor, in particular, $Al_xGa_yIn_{1-x-y}N$, the metal-organic chemical vapor deposition method of the present invention is suited.

A gas flow rate regulator includes an element capable of regulating flow rate of gas passing through with upstream gas pressure and downstream gas pressure; a first manometer for measuring pressure on the downstream side of the element; a second manometer for measuring pressure on the upstream side of the element; a thermometer for measuring temperature of the element; and a pressure regulator for regulating the gas pressure on the upstream side of the element.

According to the gas flow rate regulator of the present invention, gas pressure on the upstream side of the element is regulated based on a measurement of the first manometer and a measurement of the second manometer, and whereby flow rate of gas passing through the element can be regulated. As a result, a mass flow controller for controlling flow rate of gas is no longer needed, and the apparatus can be simplified.

A semiconductor manufacturing apparatus of the present invention includes a substrate processing chamber for processing a substrate; a plurality of channels connected to the substrate processing chamber, for feeding gas to the substrate processing chamber; and the above gas flow rate regulator provided in at least one of the plurality of channels. The plurality of channels are mutually connected on the upstream side of the gas flow rate regulator.

According to the semiconductor manufacturing apparatus of the present invention, gas pressure on the upstream side of the element is regulated based on a measurement of the first manometer and a measurement of the second manometer, and whereby flow rate of gas passing through the element can be regulated. As a result, a mass flow controller for controlling flow rate of gas is no longer needed, and the apparatus can be simplified.

A semiconductor manufacturing method of the present invention is a manufacturing method using the above semiconductor manufacturing apparatus, and includes the step of regulating pressure on the upstream side of the element by the pressure regulator.

According to the semiconductor manufacturing method of the present invention, even when change in pressure occurs on the upstream side of the element, the gas flow rate regulated by the gas flow rate regulator is hard to change.

The above manufacturing apparatus is an apparatus for forming, preferably semiconductor, more preferably a nitride compound semiconductor on a substrate by vapor deposition. Preferably, the vapor deposition is based on the hydride vapor deposition method or metal-organic chemical vapor deposition method.

The above manufacturing method further includes the step of forming preferably semiconductor, more preferably a nitride compound semiconductor on a substrate by vapor deposition. Preferably, the vapor deposition is based on the hydride vapor deposition method or metal-organic chemical vapor deposition method.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a view schematically showing the makeup of a metal-organic vaporizing and feeding apparatus according to First Embodiment of the present invention.
Fig. 2 is a view showing an example of relationship between gas pressure PA1 on the upstream side of sonic nozzle S and flow rate of gas passing through the sonic nozzle.
Fig. 3 is a view showing an example of relationship between differential pressure between gas pressure PB1 on the upstream side of laminar flow element F and gas pressure PB2 on the downstream side of the same, and flow rate of gas passing through laminar flow element F.
Fig. 4 is a view showing a modified example of metal-organic vaporizing and feeding apparatus in First Embodiment of the present invention.
Fig. 5 is a view schematically showing the makeup of a MOCVD apparatus in Second Embodiment of the present invention.
Fig. 6 is a view schematically showing the makeup of a MOCVD apparatus according in Third Embodiment of the present invention.
Fig. 7(a) is a view schematically showing the makeup of a semiconductor manufacturing apparatus in Fourth Embodiment of the present invention.
Fig. 7(b) is a view schematically showing the makeup of a flow rate regulator in Fourth Embodiment of the present invention.
Fig. 8 is a view schematically showing the makeup of a modified example of a semiconductor manufacturing apparatus in Fourth Embodiment of the present invention.
Fig. 9(a) is a view showing change in flow rate of bubbling gas passing through flow rate regulators 9A and 9B in First Embodiment of the present invention, and Fig. 9(b) is a view showing change in flow rate of dilution gas passing through dilution gas feeding path 7 in Example 1 of the present invention.
Fig. 10 is a view schematically showing the makeup of laboratory apparatus in Example 2 of the present invention.
Fig. 11 is a view schematically showing the makeup of laboratory apparatus in Example 4 of the present invention.
Fig. 12 is a view schematically showing the makeup of a conventional metal-organic vaporizing and feeding apparatus.

## DESCRIPTION OF THE PREFERRED EMBODIMENTS

In the following, Embodiments of the present invention will be explained with reference to the drawings.

First Embodiment

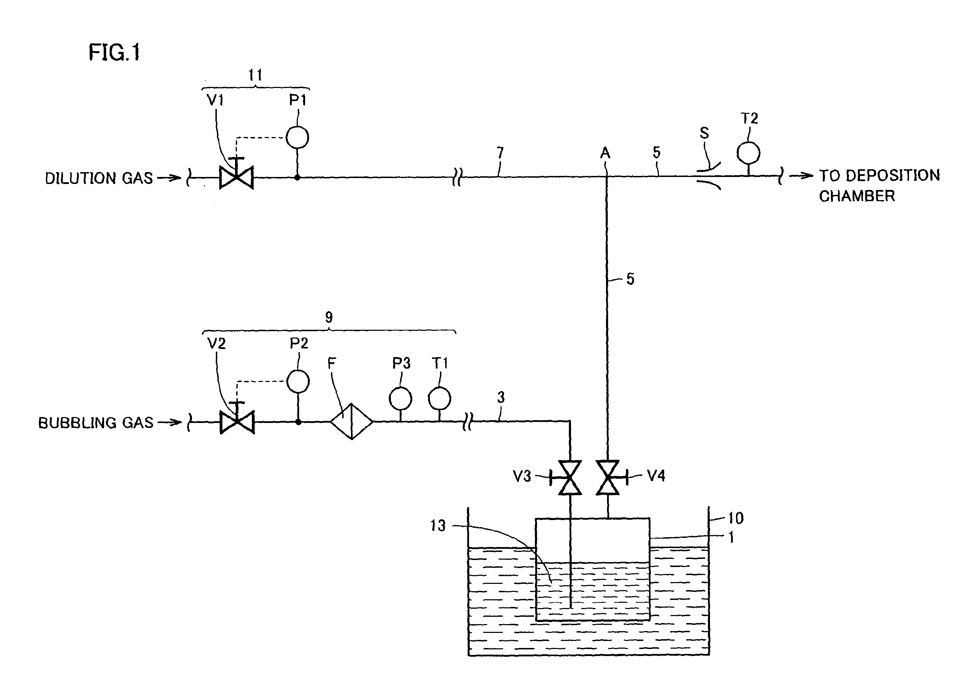

Referring to Fig. 1, a metal-organic vaporizing and feeding apparatus according to the present Embodiment includes a retention vessel 1, a bubbling gas feeding path 3, a metal-organic gas feeding path 5, a dilution gas feeding path 7, a flow rate regulator 9 serving as a gas flow rate regulator, a thermostat bath 10, a pressure regulator 11, a sonic nozzle S serving as a restrictor, valves V3 and V4, and a thermometer T2.

Within retention vessel 1, liquid of a metal-organic material 13 is retained, and on the upstream side of retention vessel 1, bubbling gas feeding path 3 is connected. Bubbling gas feeding path 3 extends to reach inside metal-organic material 13. Bubbling gas feeding path 3 is provided with flow rate regulator 9 for regulating flow rate of bubbling gas. On the downstream side of retention vessel 1, metal-organic gas feeding path 5 is connected. Metal-organic gas feeding path 5 is connected at a position where it does not come into contact with liquid metal-organic material 13. Dilution gas feeding path 7 is connected at a position A with metal-organic gas feeding path 5. Dilution gas feeding path 7 is provided with pressure regulator 11 for regulating pressure of dilution gas. Metal-organic gas feeding path 5 is provided on the downstream side of position A, with sonic nozzle S and thermometer T2 in this order from upstream side. Metal-organic gas feeding path 5 is connected on its downstream side with a deposition chamber (not shown in the drawing).

Sonic nozzle S has such characteristics that flow rate of gas passing through sonic nozzle S is equal to the sonic velocity when ratio PA2/PA1 between gas pressure PA1 on the upstream side of sonic nozzle S and gas pressure PA2 on the downstream side of sonic nozzle S is less than or equal to a certain value (critical pressure ratio). As a result, flow rate of gas passing through sonic nozzle S does not depend on downstream gas pressure, and flow rate of gas passing through sonic nozzle S can be regulated by upstream gas pressure and temperature of sonic nozzle S. To be more specific, flow rate Q of gas passing through sonic nozzle S is represented by the following formula (1):

$$Q = A \times Cd \times PA1 \times (Mw \times Cp/Cv/R/T)^{1/2} \quad (1)$$

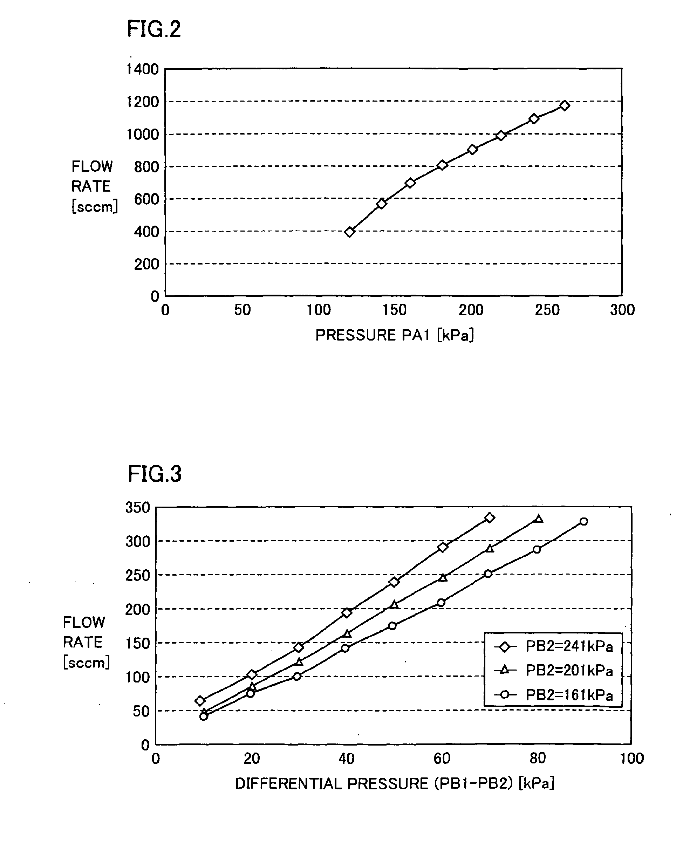

Here, sign A is constant, sign Cd is coefficient which is called "run-off coefficient" and variable depending on the kind of gas, sign Mw is molar mass of gas, sign Cp is specific heat at constant pressure, sign Cv is specific heat at constant volume, sign R is gas constant, sign T is temperature of sonic nozzle S. For example, when the critical pressure ratio PA2/PA1 is 0.52 and gas pressure PA2 on the side of the deposition chamber (on the downstream side) is equal to the atmospheric pressure, pressure PA1 on the upstream side of sonic nozzle S should be 195kPa or higher. One example of relationship between gas pressure PA1 on the upstream side of sonic nozzle S and flow rate of gas passing through sonic nozzle is shown in Fig. 2 and Table 1.

Table 1

| Pressure (kPa) | Flow rate (sccm) |
|---|---|
| 261 | 1189 |
| 241 | 1096 |
| 221 | 1004 |
| 220 | 1000 |
| 201 | 909 |
| 181 | 808 |
| 161 | 696 |
| 141 | 568 |
| 121 | 394 |

Referring to Fig. 2 and Table 1, it can be understood that flow rate of gas passing through sonic nozzle S is generally proportional to gas pressure PA1 on the upstream side of sonic nozzle S.

Pressure regulator 11 has valve V1 and manometer P1 in this order from upstream side. Valve V1 and manometer P1 are electrically connected with each other.

Referring to Fig. 1, flow rate regulator 9 has valve V2 serving as bubbling regulator, manometer P2, laminar flow element F serving as an element for bubbling gas, manometer P3, and thermometer T 1 in this order from upstream side. Valve V2 and manometer P2 are electrically connected with each other. Laminar flow element F may be in the form of, for example, a bundle of plural pipes or a porous filter, and is capable of regulating flow rate of gas passing through laminar flow element F with gas pressure PB 1 on the upstream side of laminar flow element F and gas pressure PB2 on the downstream side of laminar flow element F, and temperature of laminar flow element F. More specifically, in Fig. 1, flow rate Q of gas passing through laminar flow element is represented by the following formula (2) using Qm shown by formula (3).

$$Q=((B^2+4A \times Qm)^{1/2}-B)/2A \qquad (2)$$

$$Qm=(PB1-PB2) \times (PB1+PB2+\alpha) \times C/T \qquad (3)$$

Here, signs A, B, and C are constants, and sign T is temperature of laminar flow element F. Fig. 3 shows one example of relationship between differential pressure between gas pressure PB1 on the upstream side of laminar flow element F and gas pressure PB2 on the downstream side thereof, and flow rate of gas passing through laminar flow element F.

Referring to Fig. 3, it can be understood that flow rate of gas passing through laminar flow element F may be calculated by differential pressure between gas pressure PB1 on the upstream side of laminar flow element F and gas pressure PB2 on the downstream side thereof in any case where pressure on the downstream side PB2 are 161 kPa, 201 kPa and 241 kPa.

Referring to Fig. 1, in the metal-organic vaporizing and feeding apparatus according to the present Embodiment, metal-organic gas is fed to a deposition chamber and deposition is conducted in the manner as will be described below.

First, by opening valve V2, bubbling gas is fed to bubbling gas feeding path 3. Flow rate of bubbling gas is regulated by flow rate regulator 9 and fed into retention vessel 1 via valve V3 (flow rate regulating step). In other words, gas pressure (gas pressure on the upstream side of laminar flow element F) PB1 of bubbling gas feeding path 3 between valve V2 and laminar flow element F is regulated by valve V2 according to a value of manometer P2. Also, gas pressure PB2 on the downstream side of laminar flow element F is substantially regulated by operation of valve V1 as will be describe later according to a value of manometer P3. Temperature of laminar flow element F is measured by thermometer T1. By appropriately controlling pressure PB1 and pressure PB2 depending on the temperature of laminar flow element F, flow rate of bubbling gas which is fed into retention vessel 1 is controlled. As the bubbling gas is fed into retention vessel 1 and fed to metal-organic material 13, an amount of metal-organic gas which is suited for the amount of fed bubbling gas will be generated by bubbling. Then, the generated metal-organic gas and part of bubbling gas are fed into metal-organic gas feeding path 5 via valve V4. On the other hand, by opening valve V1, dilution gas is fed to dilution gas feeding path 7. Dilution gas is fed to metal-organic gas feeding path 5 via dilution gas feeding path 7 while its pressure is regulated by pressure regulator 11 (pressure regulating step). In pressure regulator 11, pressure of dilution gas is regulated by valve V 1 according to a value of manometer P1. Dilution gas fed to metal-organic gas feeding path 5 is mixed with metal-organic gas and bubbling gas, to form a mixed gas (mixing step). Mixed gas is regulated to a suitable flow rate through sonic nozzle S and fed to deposition chamber where deposition is conducted (depositing step).

Here, since dilution gas feeding path 7 is connected with metal-organic gas feeding path 5, pressure measured by manometer P1 is equal to pressure PA1 of metal-organic gas feeding path 5 on the upstream side of sonic nozzle S. This pressure PA1 is combined pressure of metal-organic gas, bubbling gas and dilution gas, and pressure PA 1 may be substantially regulated by means of valve V1. In sonic nozzle S, by regulating pressure measured by manometer P1 to an appropriate value by means of valve V1 based on a value of thermometer T2, flow rate of gas (organic gas) flowing on the downstream side of sonic nozzle S is regulated. In the condition that valve V3 and valve V4 are open, pressure measured at manometer P1, pressure PA1 on the upstream side of sonic nozzle S and pressure PA2 measured at manometer P3 substantially equal. Accordingly, gas pressure PB2 on the downstream side of laminar flow element F can be substantially regulated by operation of valve V1. Strictly speaking, PA2 (=PB2) is higher by a pressure corresponding to the amount of liquid metal-organic material 13.

Retention vessel 1 is located inside thermostat bath 10, and liquid temperature of metal-organic material 13 is kept constant by thermostat bath 10, and accordingly vapor pressure is kept constant. As a result, pressure of metal-organic gas in total pressure (pressure PA1) is controlled to be constant so that an amount metal-organic gas corresponding to partial pressure of metal-organic gas in flow rate of bubbling gas is fed to metal-organic gas feeding path 5.

The metal-organic vaporizing and feeding apparatus according to the present Embodiment includes retention vessel 1 for retaining metal-organic material 13, bubbling gas feeding path 3 connected to retention vessel 1, for feeding metal-organic material 13 with bubbling gas, metal-organic gas feeding path 5 connected to retention vessel 1, for feeding a deposition chamber with metal-organic gas generated in retention vessel 1 and with dilution gas, dilution gas feeding path 7 connected to metal-organic gas feeding path 5, for feeding metal-organic gas feeding path 5 with dilution gas, flow rate regulator 9 provided in bubbling gas feeding path 3, for regulating flow rate of bubbling gas, pressure regulator 11 for regulating pressure of dilution gas, and sonic nozzle S disposed in metal-organic gas feeding path 5 on the downstream side of position A. Flow rate of gas passing through may be regulated by gas pressure on the upstream side of sonic nozzle S.

According to the metal-organic vaporizing and feeding apparatus in the present Embodiment, gas pressure in metal-organic gas feeding path 5 is substantially regulated by valve V 1 of pressure regulator 11, and flow rate of gas fed to the deposition chamber is regulated by gas pressure in metal-organic gas feeding path 5. As a result, it is possible to regulate flow rate of metal-organic gas to be fed into the deposition chamber by flow rate regulator 9 and pressure regulator 11. This can dispense with a mass flow controller for controlling flow rate of dilution gas, and simplify the apparatus. With the simplification of apparatus, it is possible to reduce the production cost of metal-organic vaporizing and feeding apparatus, and to reduce the cost required for deposition according to MOCVD method.

Further, by employing sonic nozzle S as a restrictor, the apparatus can be used when the pressure on the downstream side is atmospheric pressure, and deposition may be conducted in a deposition chamber at atmospheric pressure. As a result, it is possible to obtain particularly excellent crystals of nitride semiconductor.

Flow rate regulator 9 includes laminar flow element F which is capable of regulating flow rate of gas passing through with upstream gas pressure and downstream gas pressure, and valve V2 disposed on the upstream side of laminar flow element F, for regulating pressure in bubbling gas feeding path 3.

As a result, it is possible to control flow rate of bubbling gas by pressure regulation by means of valve V2. This can dispense with a mass flow controller for controlling flow rate of bubbling gas and apparatus can be further simplified. Additionally, since pressure of bubbling gas can be regulated by means of valve V2, even when pressure of bubbling gas on the upstream side of flow rate regulator 9 (upstream pressure) suddenly changes, it is possible to prevent the change from influencing on the downstream side. In other words, a feeding source for feeding bubbling gas feeding path 3 with bubbling gas may also be used for feeding bubbling gas (hereinafter, referred to as "other gas") used for bubbling of other metal-organic gas, or used by carrier gas for convey of material, and various purge gases. In the case where the feeding source is used for feeding other gas, when feeding other gas is started while the metal-organic vaporizing and feeding apparatus of the present Embodiment is fed with bubbling gas, the original pressure of other gas will rapidly drop. Such rapid pressure drop leads change in amount of generated metal-organic gas. According to the metal-organic vaporizing and feeding apparatus of the present Embodiment, since rapid change in pressure of bubbling gas can be prevented by valve V2, change in amount of metal-organic gas can be prevented. As a result, stability in deposition and uniformity of the film are improved.

The metal-organic chemical vapor deposition method in the present Embodiment includes a flow rate regulating step of feeding bubbling gas to metal-organic material 13 3 while regulating flow rate of the bubbling gas, a pressure regulating step of regulating pressure of dilution gas, a mixing step of mixing metal-organic gas generated from metal-organic material 13 with dilution gas after the flow rate regulating step and the pressure regulating step to obtain mixed gas, and a depositing step of feeding the mixed gas to a deposition chamber through sonic nozzle S after the mixing step to conduct deposition. Sonic nozzle S is capable of regulating flow rate of gas passing through with upstream gas pressure.

According to the metal-organic chemical vapor deposition method in the present Embodiment, pressure of mixed gas of metal-organic gas and dilution gas is substantially regulated by the pressure regulating step, and flow rate of gas fed to the deposition chamber is regulated by this pressure of mixed gas. Accordingly, it is possible to regulate flow rate of the metal-organic gas to be fed into the deposition chamber by the flow rate regulating step and pressure regulating step. This dispenses with the use of a mass flow controller for controlling flow rate of dilution gas, and realizes simplification of the apparatus.

In the present Embodiment, explanation was made for the case where sonic nozzle S is used as a restrictor, however, restrictor of the present invention may be those other than sonic nozzle insofar as flow rate of gas passing through can be regulated by upstream gas pressure.

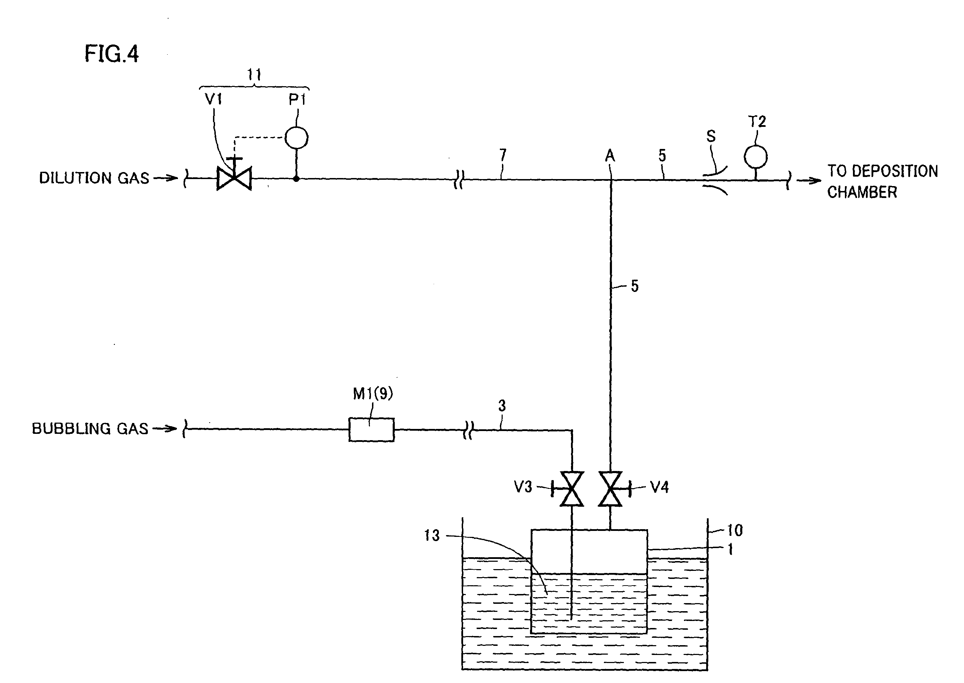

In the present Embodiment, explanation was made for the case where laminar flow element F is used as a flow rate regulator, however, the flow rate regulator of the present invention may be implemented by those other than laminar flow element insofar as flow rate of bubbling gas can be regulated. Fig. 4 is a view showing a modified example of the metal-organic vaporizing and feeding apparatus in First Embodiment of the present invention. In Fig. 4, a mass flow controller M1 is used as flow rate regulator 9. Since the makeup in Fig. 4 except for flow rate regulator 9 is as same as that in Fig. 1, explanation will not be given here.

In addition, according to flow rate regulator 9 in the present Embodiment, it is possible to regulate the gas pressure on the upstream side of laminar flow element F based on measurement of manometer P2 and measurement of manometer P3, thereby regulating flow rate of gas passing through laminar flow element F. This can dispense with a mass flow controller for controlling flow rate of gas, and realizing simplification of the apparatus.

Such gas flow rate regulator (flow rate regulator 9) is also useful in a vapor phase growing apparatus based on the hydride vapor deposition (HVPE) method as well as for use in a metal-organic vaporizing and feeding apparatus.

As disclosed for example, in Japanese Patent Laying-Open No. 2000-12900, HVPE method is one of representative production methods of a nitride compound semiconductor other than MOCVD method as disclosed, is particularly suited for manufacturing of self-standing substrate of gallium nitride. Likewise the MOCVD method, HVPE method uses ammonia, hydrogen, nitrogen and the like gas, and further uses hydrochloric acid gas. These gases are fed into a reaction furnace while their flow rates are accurately controlled. Control of flow rate is conventionally performed by an expensive mass flow controller. By using a gas flow rate regulator of the present invention, flow rates of these gases can be controlled and the apparatus can be simplified.

The flow rate regulator of the present invention has such characteristics that change in flow rate on the downstream side due to change in pressure on the upstream side (feeding side) is smaller than that in the conventional mass flow controller.

Inventors of the present invention conducted the following experiments for examine the effect of the gas flow rate regulator of the present invention. Concretely, a conventional gas flow rate regulator implemented by a mass flow controller having a full scale of 1 slm in terms of $N_2$, a conventional gas flow rate regulator implemented by a mass flow controller having a full scale of 50 slm, and a gas flow rate regulator of the present invention were prepared, and performances of these regulators were compared. Upstream pressure of $N_2$ gas at 0.2 MPa by gauge pressure was varied by using a regulator. Upstream pressure of $N_2$ gas was varied within the range of 10 to 70kPa at intervals of 1 second. Flow rate of $N_2$ gas was set at 500 sccm, 20 slm, respectively. Change in flow rate was $\pm 0.4\%$ for full scale of 1 slm and $\pm 0.2\%$ for full scale of 50 slm in the gas flow rate regulator of the present invention. On the other hand, change in flow rate in the conventional gas flow rate regulator was an average of 1.5 to 4 times larger than that of the gas flow rate regulator of the present invention.

This result is attributable to the fact that the gas flow rate regulator of the present invention is essentially tolerant to variation in upstream pressure because a pressure control valve also serves as a regulator. On the other hand, since the conventional mass flow controller has a flow rate regulation valve on the downstream side of the flow rate sensor, it is susceptible to variation in measure flow rate by variation in upstream pressure. In conclusion, according to the gas flow rate regulator of the present invention, it is possible to realize a simpler structure compared to the conventional one, reduce the cost, and achieve high accuracy.

Second Embodiment

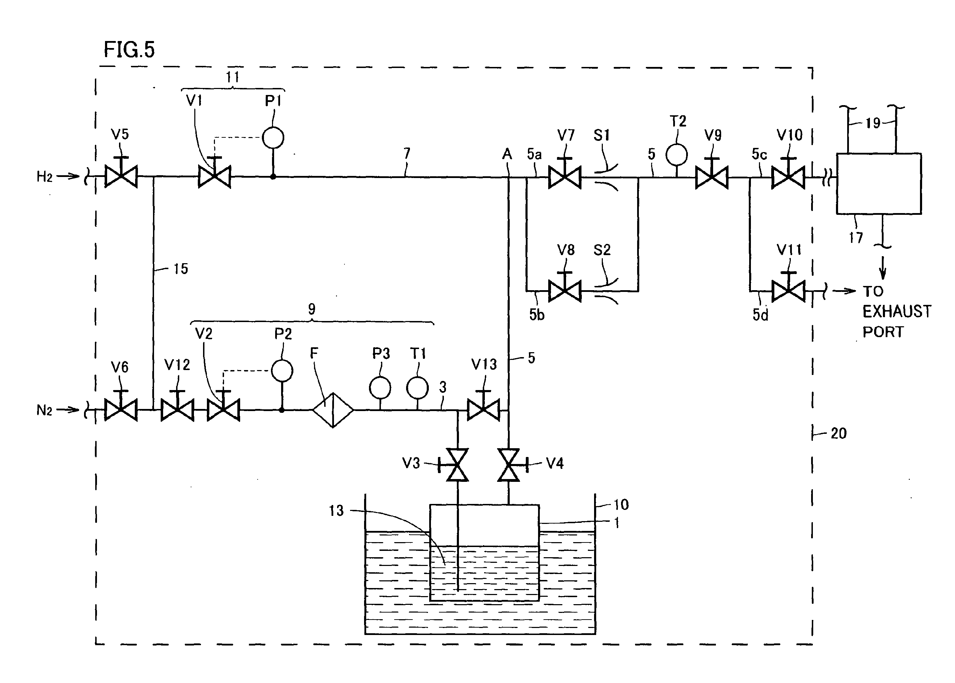

Referring to Fig. 5, a MOCVD apparatus in the present Embodiment includes a metal-organic vaporizing and feeding apparatus 20, a gas feeding path 19, and a deposition chamber 17. Metal-organic vaporizing and feeding apparatus 20 and gas feeding path 19 are both connected to deposition chamber 17, and feed deposition chamber 17 with different gases.

Metal-organic vaporizing and feeding apparatus 20 in the present Embodiment is different from the metal-organic vaporizing and feeding apparatus of First Embodiment in that $H_2$ or $N_2$ may be used as bubbling gas and dilution gas, and sonic nozzle may be switched depending on the kind of bubbling gas and dilution gas. In the following, the makeup of metal-organic vaporizing and feeding apparatus 20 will be explained.

In metal-organic vaporizing and feeding apparatus 20, there is provided a connecting path 15 that connects bubbling gas feeding path 3 on the upstream side of valve V2 and dilution gas feeding path 7 on the upstream side of valve V1. On further upstream side of the connecting position of connecting path 15, bubbling gas feeding path 3 is provided with a valve V6, and on further upstream side of the connecting position of connecting path 15, dilution gas feeding path 7 is provided with a valve V5. Valve V5 and valve V6, and connecting path 15 form a switcher that switches the kinds of bubbling gas to be fed to bubbling gas feeding path 3 and dilution gas to be fed to dilution gas feeding path 7 between $H_2$ and $N_2$ (first switcher).

Further, metal-organic gas feeding path 5 has a first feeding path 5a, a second feeding path 5b, a deposition chamber feeding path 5c, and an exhaust path 5d. On the downstream side of position A, metal-organic gas feeding path 5 is branched into first feeding path 5a and second feeding path 5b, and on further downstream side of this branching position, first feeding path 5a and second feeding path 5b are connected again. On further downstream side of the connecting position between first feeding path 5a and second feeding path 5b, metal-organic gas feeding path 5 is branched into deposition chamber feeding path 5c and exhaust path 5d. Deposition chamber feeding path 5c is connected to deposition chamber 17, and exhaust path 5d is connected to an exhaust port. First feeding path 5a is provided with a valve V7 and a sonic nozzle S 1 serving as a first restrictor in this order from upstream side, and second feeding path 5b is provided with a valve V8 and a sonic nozzle S2 serving as a second restrictor in this order from upstream side. Each of valves V7 and V8 are a switcher (second switcher) that switches the flow path of metal-organic gas and dilution gas between first feeding path 5a and second feeding path 5b.

Metal-organic gas feeding path 5 is provided with a thermometer T2 and a valve V9 at positions which are on the downstream side of the connecting position between first feeding path 5a and second feeding path 5b and on the upstream side of branching position between deposition chamber feeding path 5c and exhaust path 5d. Deposition feeding path 5c is provided with a valve V9 and exhaust path 5d is provided with a valve V11. Bubbling gas feeding path 3 is provided with a valve V12 on the downstream side of the connecting position of connecting path 15 and on the upstream side of valve V2, and a valve V 13 is provided so that it connects bubbling gas feeding path 3 on the downstream side of laminar flow element F and metal-organic gas feeding path 5 on the upstream side of position A.

In Fig. 5, flow rate Q of gas passing through the laminar flow element is represented by the above formula (2). In Fig. 5, flow rate Q of gas passing through sonic nozzles S 1 and S2 is represented by the above formula (1).

Since other structures of metal-organic vaporizing and feeding apparatus 20 are similar to those of the metal-organic vaporizing and feeding apparatus in First Embodiment shown in Fig. 1, an identical member is denoted by the same reference numeral, and explanation thereof is not given.

In metal-organic vaporizing and feeding apparatus 20 in the present Embodiment, metal-organic gas is fed to a deposition chamber and deposition is conducted in the following manner.

First, by switching between valve V5 and valve V6 while valve V12 is open, either $H_2$ or $N_2$ is fed to bubbling gas feeding path 3 as bubbling gas. That is, when $H_2$ gas is used as bubbling gas, valve V5 is opened and valve V6 is closed, whereas when $N_2$ gas is used as bubbling gas, valve V5 is closed and valve V6 is opened. Bubbling gas is fed into retention vessel 1 via valve V3 while its flow rate is regulated by flow rate regulator 9. At this time, valve V13 is closed. And metal-organic gas generated from metal-organic material 13 and part of bubbling gas is fed into metal-organic gas feeding path 5 via valve V4.

By closing valve V10 and opening valve V11 until flow rate of bubbling gas stabilizes, it is possible to make bubbling gas flow through exhaust path 5d. In this case, after the flow rate of bubbling gas has stabilized, valve V11 is closed and valve V10 is opened, and mixed gas is fed to deposition chamber 17 through deposition chamber feeding path 5c.

On the other hand, by opening valve V1, dilution gas which is the same kind as bubbling gas is fed to dilution gas feeding path 7. Pressure of dilution gas is regulated by pressure regulator 11, and fed to metal-organic gas feeding path 5 through dilution gas feeding path 7. The dilution gas fed to metal-organic gas feeding path 5 is then mixed with metal-organic gas and bubbling gas to form mixed gas.

The sonic nozzles allowing mixed gas to pass through are switched depending on kinds of dilution gas and bubbling gas (switching step). For example, when $H_2$ gas is used as dilution gas and bubbling gas, valve V7 is opened, and valve V8 is closed. As a result, mixed gas flows through first feeding path 5a and sonic nozzle S1. When $N_2$ gas is used as dilution gas and bubbling gas, valve V7 is closed and valve V8 is opened. As a result, mixed gas flows through second feeding path 5b and sonic nozzle S2. Mixed gas having passed through sonic nozzles S 1 and S2 is regulated to an appropriate flow rate, and fed to a deposition chamber via metal-organic gas feeding path 5, valve V9, deposition chamber feeding path 5c and valve V10. Then using metal-organic gas, and other gas fed from gas feeding path 19, for example, a compound semiconductor is deposited. When $Al_xGa_yIn_{1-x-y}N$ ($0 \leq x \leq 1$, $0 \leq y \leq 1$, $0 \leq x+y \leq 1$) is deposited as the compound semiconductor, for example, trimethyl aluminum (TMA) is used as metal-organic material 13, and trimethyl gallium (TMG), trimethyl indium (TMI), and ammonia ($NH_3$) serving as a group V material are fed through gas feeding path 19.

According to metal-organic vaporizing and feeding apparatus 20 in the present Embodiment, the following operational effects can be obtained as well as the effects similar to those obtained by the metal-organic vaporizing and feeding apparatus of First Embodiment.

Metal-organic gas feeding path 5 has first feeding path 5a and second feeding path 5b, sonic nozzle has sonic nozzle S 1 provided in first feeding path 5a and sonic nozzle S2 provided in second feeding path 5b, and first feeding path 5a and second feeding path 5b are connected on the downstream side of position A and on the downstream side of sonic nozzles S 1 and S2. Metal-organic vaporizing and feeding apparatus 20 is further provided with valve V5 and valve V6 for switching the kind of bubbling gas to be fed to bubbling gas feeding path 3 between $H_2$ and $N_2$, connecting path 15, and valves V7 and V8 for switching the flow path of mixed gas between first feeding path 5a and second feeding path 5b.

In the metal-organic chemical vapor deposition method in the present Embodiment, the sonic nozzle has sonic nozzle S 1 and sonic nozzle S2, and the depositing step includes a step of switching the sonic nozzle allowing mixed gas to pass through between sonic nozzle S 1 and sonic nozzle S2 depending on the kind of dilution gas or bubbling gas.

As a result, it is possible to use the sonic nozzle while selecting from sonic nozzle S1 and sonic nozzle S2 depending on the kind of bubbling gas. As a result, it is possible to prevent flow rate characteristic of gas fed into deposition chamber from changing with switching of bubbling gas to be used.

Sonic nozzles S1 and S2 may be so configured that flow rate of gas passing through sonic nozzle S 1 when bubbling gas feeding path 3 is fed with $H_2$ and the flow path of metal-organic gas is switched to first feeding path 5a and gas pressure on the upstream side of sonic nozzle S 1 has a predetermined value, is equal to flow rate of gas passing through sonic nozzle S2 when bubbling gas feeding path 3 is fed with $N_2$ and the flow path of metal-organic gas is switched to second feeding path 5b and when gas pressure on the upstream side of sonic nozzle S2 has the above predetermined value. Since different kinds of gas have different conductances to sonic nozzle, flow rate of gas passing through may largely vary when sonic nozzle of the same diameter is used while the kind of gas is changed. By configuring the sonic nozzle as describing above, it is possible to equalize flow rate of gas fed into a deposition chamber even when bubbling gas for use is switched from $H_2$ to $N_2$.

Third Embodiment

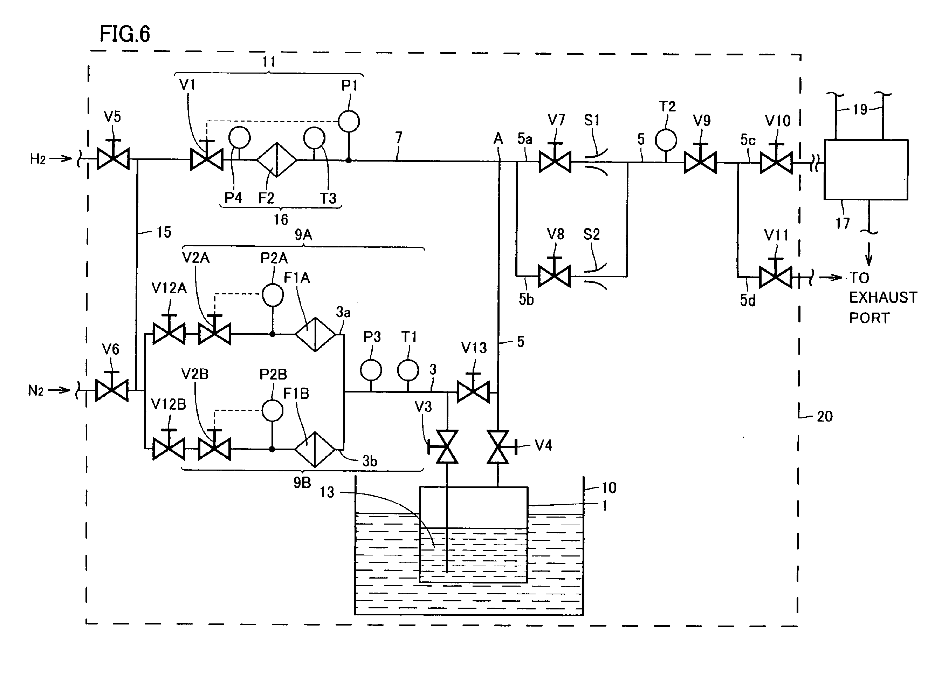

Referring to Fig. 6, a metal-organic vaporizing and feeding apparatus 20 in the present Embodiment differs from metal-organic vaporizing and feeding apparatus of Second Embodiment shown in Fig. 5 in that a dilution gas flow rate measuring part 16 is provided. In the following, the makeup of metal-organic vaporizing and feeding apparatus 20 will be explained.

Between valve V1 and manometer P1 in dilution gas feeding path 7, there is provided dilution gas flow rate measuring part 16. Dilution gas flow rate measuring part 16, a manometer P4 serving as manometer for dilution gas, a laminar flow element F2 serving as element for dilution gas, and a thermometer T3 in this order from upstream side. Bubbling gas feeding path 3 has a first bubbling gas feeding path 3a and a second bubbling gas feeding path 3b. On the down stream side of the connection position with connecting path 15, first bubbling gas feeding path 3a and second bubbling gas feeding path 3b are branched, and at the position on the downstream side of the branching position and on the upstream side of the position where manometer P3 is provided, first bubbling gas feeding path 3a and second bubbling gas feeding path 3b are connected again.

First bubbling gas feeding path 3 a is provided with valve V12A, valve V2A, manometer P2A, and laminar flow element F1A in this order from upstream side. Valve V2A and manometer P2A are electrically connected with each other. Valve V2A, manometer P2A, laminar flow element F1A, manometer P3, and thermometer T 1 constitute flow rate regulator 9A for regulating flow rate of gas passing through first bubbling gas feeding path 3a. In other words, based on gas pressure on the upstream side of laminar flow element F1A measured by manometer P2A, gas pressure on the downstream side of laminar flow element F1A measured by manometer P3, and temperature of laminar flow element F1A measured by thermometer T3, flow rate of gas passing through bubbling gas feeding path 3a is determined, and valve V2A is controlled based on the calculated gas flow rate, and flow rate of gas passing through first bubbling gas feeding path 3a is regulated.

Similarly, second bubbling gas feeding path 3b is provided with valve V I 2B, valve V2B, manometer P2B, and laminar flow element F1B in this order from upstream side. Valve V2B and manometer P2B are electrically connected with each other. Valve V2B, manometer P2B, laminar flow element F1B, manometer P3, and thermometer T1 constitute flow rate regulator 9B for regulating flow rate of gas passing through second bubbling gas feeding path 3b.

Laminar flow elements F1A and F1B differ from each other in flow rate of gas passing through when differential pressure between upstream side and downstream side is identical. For example, they are so designed that when differential pressure between upstream gas pressure and downstream gas pressure is a certain value, laminar flow element F1A allows passage of gas at 300 sccm and laminar flow element F1B allows passage of gas at 20 sccm.

Other structures of metal-organic vaporizing and feeding apparatus 20 is similar to that of metal-organic vaporizing and feeding apparatus in Second Embodiment shown in Fig. 5, and hence the identical member is denoted by the same reference numeral and description thereof will not be repeated.

According to metal-organic vaporizing and feeding apparatus 20 in the present invention, it is possible to change flow rate of bubbling gas. More specifically, when a large amount of bubbling gas is passed through bubbling gas feeding path 3, valve V12A is opened and valve V12B is closed while valve V5 or valve V6 is open, and bubbling gas is allowed to pass through first bubbling gas feeding path 3a. When a small amount of bubbling gas is passed through bubbling gas feeding path 3, valve V12B is opened and valve V12A is closed while valve V5 or valve V6 is open, and bubbling gas is allowed to path through second bubbling gas feeding path 3b.

In addition, kinds of bubbling gas and dilution gas may be changed. To be more specific, when dilution gas and bubbling gas are switched from $N_2$ gas to $H_2$ gas, valve V6 is closed and valve V5 is opened likewise the case of Second Embodiment. At this time, valve V8 is closed and valve V7 is opened, and sonic nozzle to be used is switched from sonic nozzle S2 to sonic nozzle S1.

Since $N_2$ gas remains in retention vessel 1 immediately after switching of dilution gas and bubbling gas, the gas that passes through sonic nozzle S 1 contains not only $H_2$ gas but also $N_2$ gas. Since conductance of $N_2$ gas is smaller than conductance of $H_2$ gas, flow rate of gas passing through sonic nozzle S 1 is smaller than that in the case

of pure $H_2$ gas when $N_2$ gas is contained in $H_2$ gas. This impairs stability in deposition. Additionally, since the flow rate changes, it is impossible to control with a constant gas flow rate. In addition, fatal influence may be exerted on the characteristics depending on the kind of a film to be deposited. For example, when three-dimensional mixed crystal film represented by $In_xGa_{1-x}N$ is to be deposited, hydrogen contained in the gas will hinder incorporation of In, and In composition will be considerably reduced. Therefore, the kind of gas including bubbling gas is limited to $N_2$ gas (including ammonia). In other word, when bubbling by $H_2$ gas is switched to bubbling by $N_2$ gas, it is necessary to sufficiently conduct pre-bubbling to replace the gas inside the retention vessel with $N_2$ gas. Therefore, after switching of dilution gas and bubbling gas, pre-bubbling is conducted so as to discharge the remaining gas.

As the flow rate of gas passing through sonic nozzle S 1 is reduced, pressure in sonic nozzle S 1 on the upstream side increases and measurement of manometer P 1 increases. Since valve V1 is controlled so that the value of manometer P1 is kept constant, valve V1 is closed when the measurement of manometer P1 increases, and flow rate of dilution gas in dilution gas feeding path 7 decreases. On the other hand, when pre-bubbling is conducted for a certain time after switching, new dilution gas and bubbling gas is charged inside retention vessel 1, and flow rate of dilution gas increases and converges to a certain value. According to metal-organic vaporizing and feeding apparatus 20 in the present Embodiment, by measuring such change in flow rate of dilution gas (measuring step), and depositing film after flow rate of dilution gas is converged to a certain value, it is possible to omit additional pre-bubbling and reduce the time for pre-bubbling.

Measurement of flow rate of dilution gas is concretely conducted in the following manner. Manometer P4 measures gas pressure PB1 on the upstream side of laminar flow element F2, and manometer P1 measures gas pressure PB2 on the downstream side of laminar flow element F2, and thermometer T3 measures temperature T of laminar flow element F2. Then using the foregoing formulas (2) and (3), flow rate Q of gas passing through laminar flow element F2 is calculated.

In the present Embodiment, explanation was made for the case where dilution gas flow rate measuring part 16 is implemented by manometer P4, laminar flow element F2 and thermometer T3, however, according to the present invention, dilution gas flow rate measuring part may be implemented by a mass flow meter as well.

In Second and Third Embodiments, explanation was made for the case where $H_2$ or $N_2$ is used as bubbling gas and dilution gas, however, other gases than $H_2$ and $N_2$, for example Ar or He gas may be used. In the present Embodiment, explanation was made for the case where the same kind of gas is used for bubbling gas and dilution gas, however different kinds of gases may be used for bubbling gas and dilution gas.

Fourth Embodiment

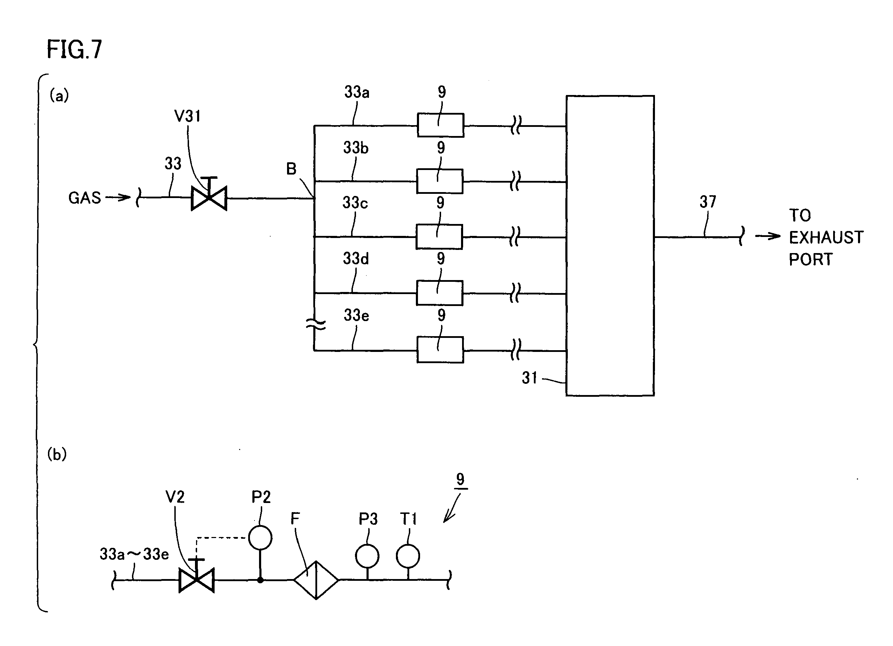

Referring to Fig. 7(a), a semiconductor manufacturing apparatus in the present Embodiment has a substrate processing chamber 31, gas feeding paths 33a to 33e which are a plurality of channels, and a flow rate regulator 9 (gas flow rate regulator). To substrate processing chamber 31, each of gas feeding paths 33a to 33e is connected, and to each of gas feeding paths 33a to 33e, respective flow rate regulator 9 is connected. Gas feeding paths 33a to 33e are mutually connected at position B on the upstream side of flow rate regulator 9, and is provided with a pressure reducing valve V31 as necessary in gas feeding path 33 on the upstream side of position B.

Referring to Fig. 7(a) and 7(b), flow rate regulator 9 is provided for regulating flow rate of gas passing through each of gas feeding paths 33a to 33e, and is structured similarly to flow rate regulator 9 shown in Fig.1. That is, flow rate regulator 9 has valve V2 (pressure regulator), manometer P2 (second manometer), laminar flow element F, manometer P3 (first manometer) and thermometer T1 in this order from upstream side. Valve V2 and manometer P2 are electrically connected with each other. Manometer P2 is provided for measuring pressure on the upstream side of laminar flow element F, and manometer P3 is provided for measuring pressure on the downstream side of laminar flow element F, and thermometer T1 is provided for measuring temperature of laminar flow element F. Laminar flow element F is capable of regulating flow rate of gas passing through laminar flow element F based on gas pressure PB1 on the upstream side of laminar flow element F, gas pressure PB2 on the downstream side of laminar flow element F, and temperature of laminar flow element F.

In the semiconductor manufacturing apparatus in the present Embodiment, a semiconductor device is produced in the following manner. First, a substrate to be processed is placed inside substrate processing chamber 31. Then, using pressure reducing valve V31, pressure of gas to be fed into gas feeding path 33 is appropriately regulated. Then in each of gas feeding paths 33a to 33e, gas pressure PB1 on the upstream side of laminar flow element F is regulated by valve V2 according to a value of manometer P2. As a result, flow rate of gas passing through laminar flow element F is appropriately regulated, and the gas is fed to substrate processing chamber 31 through each of gas feeding paths 3 3 a to 33e. Inside substrate processing chamber 31, a semiconductor such as nitride semiconductor is formed on a substrate, for example, by HVPE method, MOCVD method and the like phase-growth method. Then the exhaust gas is discharged outside through an exhaust gas pipe 37 from substrate processing chamber 31.

Flow rate regulator 9 in the present Embodiment has laminar flow element F which is capable of regulating flow rate of gas passing through with upstream gas pressure PB1 and downstream gas pressure PB2, manometer P3 for measuring pressure PB2, manometer P2 for measuring pressure PB1, and thermometer T1 for measuring temperature of laminar flow element F, and valve V2 for regulating gas pressure PB1.

Further, the semiconductor manufacturing apparatus in the present Embodiment includes substrate processing chamber 31 for processing a substrate, a plurality of gas feeding paths 33 to 33e connected to substrate processing chamber 31, for feeding gas to substrate processing chamber 31, and flow rate regulator 9 provided in each of plural gas feeding paths 33a to 33e. Gas feeding paths 3 3 a to 33e are mutually connected at position B.

Further, the semiconductor manufacturing method in the present Embodiment is a production method using the semiconductor manufacturing apparatus shown in Fig. 7, and includes the step of regulating pressure PB1 by means of valve V2.

According to flow rate regulator 9, semiconductor manufacturing apparatus and semiconductor manufacturing method in the present Embodiment, gas pressure PB1 is regulated by measurement of manometer P2 and measurement of manometer P3, and whereby flow rate of gas passing through laminar flow element F can be regulated. This dispenses with a mass flow controller for controlling gas flow rate and realizes simplification of the apparatus. In addition, gas flow rate can be regulated more accurately than by a mass flow controller, because influence of change in gas flow rate and change in pressure on the upstream side of flow rate regulator 9 is small.

In the semiconductor manufacturing apparatus shown in Fig. 7, in particular, a large number of gas feeding paths 33a to 33e are connected in parallel. Each of gas feeding paths 33a to 33e is allocated to a gas flow path intended, for example, for gas for feeding material, purge gas, or dilution gas. Conventionally, each of gas feeding paths 33a to 33e is provided with a mass flow controller. Mass flow controller has various full-scale ranging from several sccm to several hundreds of slm (maximum flow rate to which flow rate can be regulated).

In the semiconductor manufacturing apparatus shown in Fig. 7, when flow rate of gas passing through one of gas feeding paths is changed, pressure on the upstream side of gas feeding paths 33 largely changes. When a mass flow controller having large full-scale is provided as flow rate regulator 9 in each of gas feeding paths 33a to 33e, change in pressure on the upstream side of flow rate regulator 9 largely influences on flow rate of gas passing through other gas feeding paths. As a result, in the conventional semiconductor manufacturing apparatus, it was impossible to finely control the gas flow rate.

To reduce the influence of change in pressure on the upstream side on the flow rate of gas passing through other gas feeding paths, a pressure reducing valve may be individually provided on the upstream side of each mass flow controller, or a self pressure reducing valve may be provided inside the mass flow controller. However, these methods require additional structures such as pressure reducing valve and self pressure reducing valve, and increase in the costs.

On the other hand, in the present Embodiment, since laminar flow element F is used as flow rate regulator 9, it is possible to reduce the influence of change in pressure on the upstream side, on flow rate of gas, and to prevent rising of cost. Additionally, flow rate in a wide range can be controlled. In a semiconductor manufacturing apparatus, in particular, since it is often the case that the same kind of gas (for example, $H_2$ gas, $N_2$ gas, $NH_3$ gas, or hydrogen chloride (HCl) gas) is fed to a substrate processing chamber through gas feeding lines which are connected in parallel, the present invention is useful in this respect.

In the present Embodiment, explanation was made for the case where a flow rate regulator shown in Fig. 7(b) is used as flow rate regulator 9 provided in each of gas feeding paths 33a to 33e, however, in the semiconductor manufacturing apparatus of the present invention, it suffices that a flow rate regulator shown in Fig. 7(b) is provided as flow rate regulator 9 in at least one gas feeding path of gas feeding paths 33a to 33e. In this case, a mass flow controller may be used as part of flow rate regulator 9.

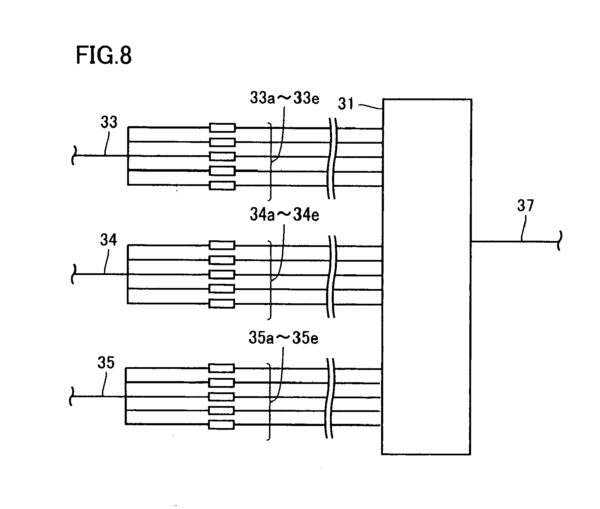

In Fig. 7(a), only one set of gas feeding paths 33a to 33e for feeding a kind of gas is illustrated, however, plural sets of gas feeding paths may be provided depending on the kind of gas in use. That is, as shown in Fig. 8, besides the sets of gas feeding paths 33a to 33e branched from gas feeding path 33, a set of gas feeding paths 34a to 34e branched from gas feeding path 34, and a set of gas feeding paths 35a to 35e branched from gas feeding path 35 are provided, and each gas feeding path is provided with a gas flow rate regulator, and each gas feeding path may be connected to substrate processing chamber 31. As a result, it is possible to realize a semiconductor manufacturing apparatus in which flow rates of plural kinds of gas can be controlled with high accuracy and low costs.

Example 1

Using a metal-organic vaporizing and feeding apparatus shown in Fig. 6, trimethyl gallium (TMGa) was subjected to bubbling, and flow rate of dilution gas under bubbling was measured. In brief, first, valves V5 and V12B are closed, and valves V6 and V12A were opened, and $N_2$ gas was fed into retention vessel 1 at a flow rate of 50 sccm. At this time, valve V7 was closed and valve V8 was opened, and flow rate of metal-organic gas was regulated using sonic nozzle S2. After a lapse of a certain time, valves V6 and V 12A were closed and valves V5 and V12B were opened, and $H_2$

gas was fed into retention vessel 1 at a flow rate of 20 sccm for a certain time. At this time, valve V8 was closed and valve V7 was opened, and flow rate of metal-organic gas was regulated using sonic nozzle S1. After a lapse of another certain time, valve V5 was closed and valve V6 was opened, and $N_2$ gas was fed into retention vessel 1 at a flow rate of 20 sccm. At this time, valve V7 was closed and valve V8 was opened, and flow rate of metal-organic gas was regulated using sonic nozzle S2. During bubbling, temperature inside the retention vessel was kept at 20°C, and pressure of bubbler was kept at 250kPa by controlling valve V1. Flow rate of dilution gas was measured by dilution gas flow rate measuring part 16.

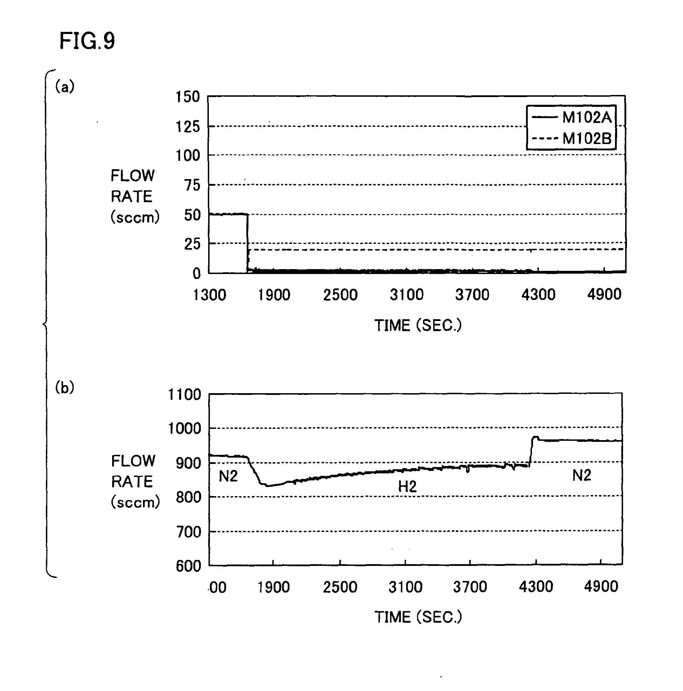

Referring to Figs. 9(a) and (b), immediately after switching bulling gas and dilution gas from $N_2$ gas at a flow rate of 50 sccm to $H_2$ gas at a flow rate of 20 sccm at around 1600 sec., flow rate of $H_2$ gas which is dilution gas temporally decrease to about 800 sccm, and then increases again to converge to about 900 sccm. On the other hand, immediately after switching bubbling gas and dilution gas from $H_2$ gas at a flow rate of 20 sccm to $N_2$ gas at a flow rate of 20 sccm at around 4200 sec., flow rate of $N_2$ gas which is dilution gas remains at about 960 sccm without exhibiting little decrease. This result reveals that whether or not replacement of bubbling gas inside retention vessel 1 has completed can be determined by providing dilution gas flow rate measuring part 16. Further, it was found that pre-bubbling requires longer time in switching from $N_2$ gas to $H_2$ gas, than in switching from $H_2$ gas to $N_2$ gas.

Example 2

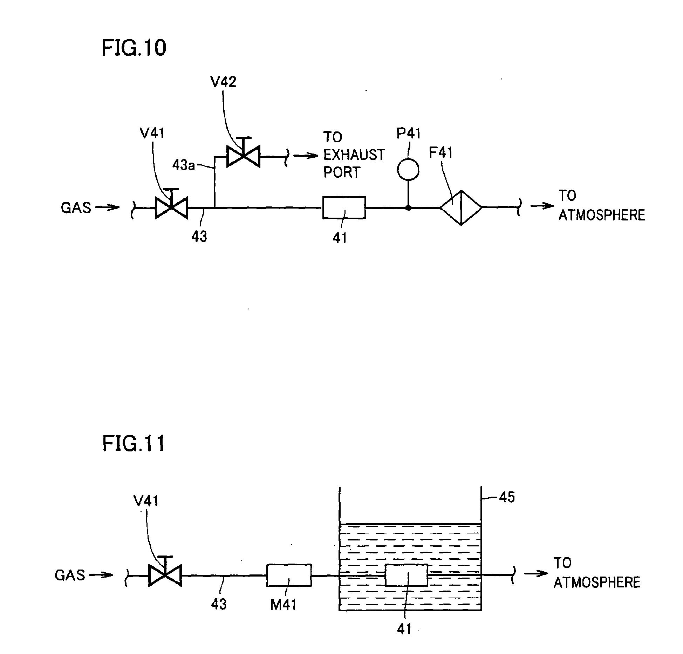

In this Example, response of actual flow rate with respect to setting value of flow rate regulator was examined. Fig. 10 is a view schematically showing the makeup of a laboratory apparatus in Example 2 of the present invention. Referring to Fig. 10, the laboratory apparatus of the present Example has a pressure reducing valve V41 and a valve V42, a flow rate regulator 41, a manometer P41, and a laminar flow element F41. A gas feeding pipe 43 is provided with pressure reducing valve V41, flow rate regulator 41, manometer P41, and laminar flow element F41 in this order from upstream side. A gas feeding pipe 43a is branched from gas feeding pipe 43 between pressure reducing valve V41 and flow rate regulator 41. Gas feeding pipe 43a is provided with valve V42. And gas feeding pipe 43 communicates at its downstream side with atmosphere, and gas feeding pipe 43a communicates on the downstream side with an exhaust port.

In Example 2 of the present invention, flow rate regulator 9 shown in Fig. 1 was provided as flow rate regulator 41 in this laboratory apparatus. As valve V2 of flow rate regulator 9 in Example 2 of the present invention, a solenoid valve was used. A solenoid valve controls valve by a magnetic field occurring upon application of electric current to coil.

In Comparative Example 1, a mass flow controller having a piezo valve was provided as flow rate regulator 41. A piezo valve controls a valve by compressing/expanding a piezo device depending on presence/absence of electric current.

In Comparative Example 2, a mass flow controller having a thermal-type valve was provided as flow rate regulator 41. A thermal-type valve controls valves by heat generated at a resistor upon application of electric current.

Using these laboratory apparatuses, experiment was conducted in the following manner. Setting value of flow rate of flow rate regulator 41 was rapidly increased from 0 (no electric current) to 10%, 50% and 100% of full scale (100 sccm) of flow rate regulator 41. Then from value of manometer P41 and atmospheric pressure, flow rate of gas passing through laminar flow element F41 was calculated and gas flow rate on the downstream side was calculated. Then, a time until gas flow rate of downstream side converges within 0.5% of setting value of flow rate regulator was counted. As the gas, $N_2$ and $H_2$ were used.

Response speed of manometer P41 was less than 10 msec, and delay of measurement system by gas compression and volume was ignorable. Pressure on the upstream side of flow rate regulator 41 was adjusted to 0.3 MPa by means of pressure reducing valve V41. Results of Example of the present invention are shown in Table 2.

Table 2

| Kind of gas and change in flow rate | Example 2 (inventive) | Comparative Example 1 | Comparative Example 2 |
|---|---|---|---|
| $N_2$ gas: 0→10% | 0.7 sec. | 5.0 sec. | 5.5 sec. |
| $N_2$ gas: 0→50% | 1.7 sec. | 2.6 sec. | 14.5 sec. |
| $N_2$ gas: 0→100% | 2.8 sec. | 1.8 sec. | 22.0 sec. |
| $H_2$ gas: 0→10% | 0.7 sec. | 4.3 sec. | 2. 5 sec. |
| $H_2$ gas: 0→50% | 1.4 sec. | 5.0 sec. | 8.0 sec. |
| $H_2$ gas: 0→100% | 2. 8 sec. | 1.9 sec. | 10.0 sec. |

Referring to Table 2, similar results were obtained on either case where $N_2$ or $H_2$ gas was used. In other words, when the gas flow rate was increased to 10% and to 50%, converging time of Example 2 of the present invention was shorter than those of Comparative Examples 1 and 2. Further, when gas flow rate was increased to 100%, converging time of Example 2 of the present invention was similar to that of Comparative Example 1, and shorter than that of Comparative Example 2. These results demonstrate that sufficiently quick response is achieved by the gas flow rate regulator of the present invention.

Example 3

In this Example, influence of change in pressure on the upstream side exerted on gas flow rate was examined. Concretely, experiment was conducted using a laboratory apparatus of Fig. 10 in the following manner. By opening/closing valve V42, pressure on the upstream side of flow rate regulator 41 was rapidly changed in the range of 0.05 MPa for $N_2$, and 0.03 MPa for $H_2$. Then flow rate of gas passing through laminar flow element F41 was calculated from value of manometer P41 and atmospheric pressure, and gas flow rate on the downstream side was measured. Setting value of gas flow rate regulator was 50 sccm. Then, a time until change in downstream gas flow rate converges within 0.5% of full scale, and a maximum value of change in downstream gas flow rate were measured.

Other experimental conditions were similar to those in Example 2. Results of converging time of downstream gas flow rate are shown in Table 3, and results of maximum value of change in gas flow rate on the downstream side are shown in Table 4. In Table 4, the notation "+" means that downstream gas flow rate has increased, and notation "-" means that downstream gas flow rate has decreased.

Table 3

| Kind of gas and change in pressure | Example 3 (inventive) | Comparative Example 1 | Comparative Example 2 |
|---|---|---|---|
| $N_2$ gas: 0.3MPa→0.25MPa | 0.9 sec. | 0.5 sec. | 5.0 sec. |
| $N_2$ gas: 0.25MPa→0.3MPa | 2.1 sec. | 1.1 sec. | 9.4 sec. |
| $H_2$ gas: 0.28MPa→0.25MPa | 0.8 sec. | 0.4 sec. | 2.6 sec. |
| $H_2$ gas: 0.25MPa→0.28MPa | 0.8 sec. | 0.6 sec. | 1.6 sec. |

Table 4

| Kind of gas and change in pressure | Example 3 (inventive) | Comparative Example 1 | Comparative Example 2 |
|---|---|---|---|
| $N_2$ gas: 0.3MPa→0.25MPa | -2.5% | +60% | -13% to +9.8% |
| $N_2$ gas: 0.25MPa→0.3MPa | +7.5% to -2.2% | -42% | -23% to +9.8% |
| $H_2$ gas: 0.28MPa→0.25MPa | -4.0% | +20% | +20% |
| $H_2$ gas: 0.25MPa→0.28MPa | +4.5% | -10% | -34% |

Referring to Table 3 and Table 4, converging time of Example 3 of the present invention was similar to that of Comparative Example 1 and much shorter than that of Comparative Example 2. Further, change in Example 3 of the present invention was much smaller than those of Comparative Examples 1 and 2. This result is attributable to the structure of mass flow controller. In other words, a mass flow controller has such a structure that it measures pressure in a branched path branched from gas feeding path and controls pressure of gas flowing through gas feeding pipe based on the measured pressure. For this reason, when upstream pressure rapidly changes, the pressure in the branched path is unable to follow the pressure in the gas feeding pipe due to influence of retention of gas within the gas feeding pipe. As a result, difference arises between gas density in the gas feeding pipe and gas density in the branched path, and accurate flow rate can not be measured, and adverse affect is exerted on downstream gas flow rate. On the other hand, in Example 3 of the present invention, since upstream pressure is controlled by valve V2, influence exerted on gas flow rate by change in pressure on the upstream side is small.

These results demonstrate that according to the gas flow rate regulator and semiconductor manufacturing apparatus of the present invention, influence exerted on downstream gas flow rate by change in pressure on the upstream side is small.

Example 4

In this Example, influence of change in temperature on flow rate regulator was examined. Fig. 11 is a view schematically showing the makeup of a laboratory apparatus in Example 4 of the present invention. Referring to Fig. 11, the laboratory apparatus of Example 4 of the present invention has pressure reducing valve V41, mass flow controller M41, flow rate regulator 41, and thermostat bath 45. Gas feeding pipe 43 is provided with pressure reducing valve V41, mass flow controller M41, and flow rate regulator 41 in this order from upstream side. Flow rate regulator 41 is disposed within thermostat bath 45. From flow rate regulator 41, flow rate of gas passing through flow rate regulator 41 is outputted.

In Example 4 of the present invention, flow rate regulator 9 shown in Fig. 1 was provided as flow rate regulator 41 in this laboratory apparatus. In Comparative Example 1, a mass flow controller having a piezo valve was provided as flow rate regulator 41. Further, In Comparative Example 2, a mass flow controller having a thermal-type valve was provided as flow rate regulator 41.

Using these laboratory apparatuses, experiment was conducted in the following manner. Pressure was regulated by pressure reducing valve V41, and gas flow rate was regulated by mass flow controller M41, and $N_2$ gas was continued to flow in flow rate regulator 41 at 50 sccm. Valve of flow rate regulator 41 was fully opened while regulating of gas flow rate by flow rate regulator 41 was not conducted. In this condition, by changing temperature of thermostat bath 45, temperature of flow rate regulator 41 was rapidly varied within the range of 10°C to 40°C. Then flow rate of gas passing through flow rate regulator 41 was measured, and maximum value of change in gas flow rate was determined.

Other experimental conditions were similar to those in Example 2. Results of Example 4 of the present invention are shown in Table 5. Maximum value of change in gas flow rate in Table 5 is shown by proportion (percentage) to full scale of flow rate regulator 41.

Table 5

| Change in temperature | Example 4 (inventive) | Comparative Example | Comparative Example 2 |
|---|---|---|---|
| 25°C → 40°C | 0.9% | 1.2% | 1.6% |
| 40°C → 10°C | 1.4% | 1.8% | 3.0% |
| 10°C → 25°C | 1.1% | 1.2% | 1.7% |

Referring to Table 5, variation occur in any measurements of flow rate regulator although gas flows actually at a constant flow rate. However, change in measurement of Example 4 of the present invention was much smaller than changes in measurements of Comparative Examples 1 and 2 regardless of the manner in which temperature of flow rate regulator 41 is changed. This result may be attributable to structure of mass flow controller. That is, in a mass flow controller, since flow rate is measured by a thermal sensor in branched path, measurement is greatly influenced by change in temperature of mass flow controller. Contrarily, in Example 4 of the present invention, since measurement is calibrated based on temperature of laminar flow element F measured by thermometer T1, measurement is hard to be influenced by temperature.

From these results, it was found that according to the gas flow rate regulator and the semiconductor manufacturing apparatus of the present invention, influence of change in temperature on the flow rate regulator is small.

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A metal-organic vaporizing and feeding apparatus comprising:

a vessel (1) for retaining a metal-organic material (13);
a bubbling gas feeding path (3) connected to said vessel, for feeding bubbling gas to said metal-organic material;
a metal-organic gas feeding path (5) connected to said vessel, for feeding metal-organic gas generated in said vessel and dilution gas for diluting said metal-organic gas to a deposition chamber (17);
a dilution gas feeding path (7) connected to said metal-organic gas feeding path, for feeding said dilution gas to said metal-organic gas feeding path;
a flow rate regulator (9) provided in said bubbling gas feeding path, for regulating flow rate of said bubbling gas;
a pressure regulator (11) for regulating pressure of said dilution gas; and

a restrictor (5) disposed in said metal-organic gas feeding path on a downstream side of a connecting position (A) between said metal-organic gas feeding path and said dilution gas feeding path, wherein
said restrictor is capable of regulating the flow rate of gas passing through with upstream gas pressure.

2. The metal-organic vaporizing and feeding apparatus according to claim 1, wherein said flow rate regulator (9) has an element (F) for bubbling gas capable of regulating the flow rate of gas passing through with upstream gas pressure and downstream gas pressure, and a bubbling gas pressure regulator (V2) disposed on an upstream side of said element for bubbling gas, for regulating pressure in said bubbling gas feeding path (3).

3. The metal-organic vaporizing and feeding apparatus according to claim 1, wherein
said metal-organic gas feeding path (5) has a first feeding path (5a) and a second feeding path (5b), said restrictor has a first restrictor (S1) disposed in said first feeding path and a second restrictor (S2) disposed in said second feeding path, and said first feeding path and said second feeding path are connected on the downstream side of said connecting position (A) and on a downstream side of said first restrictor and said second restrictor, and
the metal-organic vaporizing and feeding apparatus further comprises:

a first switcher (V5, V6, 15) for switching a kind of said bubbling gas between first bubbling gas and second bubbling gas; and
a second switcher (V7, V8) for switching a flow path of said metal-organic gas and said dilution gas between said first feeding path and said second feeding path.

4. The metal-organic vaporizing and feeding apparatus according to claim 3, wherein said first restrictor (S 1) and said second restrictor (S2) are so configured that flow rate of gas passing through said first restrictor when said bubbling gas feeding path (3) is fed with said first bubbling gas and the flow path of said metal-organic gas is switched to said first feeding path (5a) and when gas pressure on an upstream side of said first restrictor has a predetermined value, is equal to flow rate of gas passing through said second restrictor when said bubbling gas feeding path is fed with said second bubbling gas and the flow path of said metal-organic gas is switched to said second feeding path (5b) and when gas pressure on an upstream side of said second restrictor has said predetermined value.

5. The metal-organic vaporizing and feeding apparatus according to claim 1, further comprising:

a dilution gas flow rate measuring part (16) disposed in said dilution gas feeding path (7), for measuring flow rate of said dilution gas.

6. The metal-organic vaporizing and feeding apparatus according to claim 5, wherein said dilution gas flow rate measuring part (16) has:

an element (F2) for dilution gas capable of regulating flow rate of gas passing through with upstream gas pressure and downstream gas pressure;
a manometer (P4) for dilution gas for measuring pressure on an upstream side of said element for dilution gas; and
a thermometer (T3) for measuring temperature of said element for dilution gas.

7. A metal-organic chemical vapor deposition apparatus comprising:

the metal-organic vaporizing and feeding apparatus (20) according to claim 1;
a gas feeding path (19) for feeding other gas used for deposition to said deposition chamber (17); and
said deposition chamber for conducting deposition using said metal-organic gas and said other gas.

8. A metal-organic chemical vapor deposition method comprising:

a flow rate regulating step of feeding bubbling gas to a metal-organic material (13) while regulating flow rate of said bubbling gas;
a pressure regulating step of regulating pressure of dilution gas;
a mixing step of mixing metal-organic gas generated from said metal-organic material with said dilution gas after said flow rate regulating step and said pressure regulating step to obtain mixed gas; and
a depositing step of feeding said mixed gas to a deposition chamber through a restrictor (S) after said mixing step to conduct deposition, wherein
said restrictor is capable of regulating flow rate of gas passing through with upstream gas pressure.

9. The metal-organic chemical vapor deposition method according to claim 8, wherein
said restrictor (S) has a first restrictor (S1) and a second restrictor (S2), and
said depositing step includes a switching step of switching the restrictor allowing said mixed gas to pass through from said first restrictor to said second restrictor depending on a kind of said dilution gas or said bubbling gas.

10. The metal-organic chemical vapor deposition method according to claim 8, further comprising:

   a measuring step of measuring flow rate of said dilution gas, wherein
   said depositing step is conducted after the flow rate of said dilution gas is converged to a predetermined value in said measuring step.

11. The metal-organic chemical vapor deposition method according to claim 8, wherein a compound semiconductor is deposited in said depositing step.

12. The metal-organic chemical vapor deposition method according to claim 11, wherein said compound semiconductor is made of $Al_xGa_yIn_{1-x-y}N$ ($0 \leq x \leq 1$, $0 \leq y \leq 1$, $0 \leq x+y \leq 1$).

13. A gas flow rate regulator (9) comprising:

   an element (F) capable of regulating flow rate of gas passing through with upstream gas pressure (PB 1) and downstream gas pressure (PB2);
   a first manometer (P3) for measuring pressure on a downstream side of said element;
   a second manometer (P2) for measuring pressure on an upstream side of said element;
   a thermometer (T1) for measuring temperature of said element; and
   a pressure regulator (V2) for regulating said gas pressure on the upstream side of said element.

14. A semiconductor manufacturing apparatus comprising:

   a substrate processing chamber (31) for processing a substrate;
   a plurality of channels (33a-33e) connected to said substrate processing chamber, for feeding gas to said substrate processing chamber; and
   the gas flow rate regulator (9) according to claim 13 disposed in at least one of said plurality of channels, wherein said plurality of channels are mutually connected on an upstream side of said gas flow rate regulator.

15. The semiconductor manufacturing apparatus according to claim 14, for depositing a semiconductor film on said substrate by vapor deposition.

16. The semiconductor manufacturing apparatus according to claim 15, for forming a nitride compound semiconductor on said substrate by vapor deposition.

17. The semiconductor manufacturing apparatus according to claim 15, wherein said vapor deposition is based on a hydride vapor deposition method.

18. The semiconductor manufacturing apparatus according to claim 15, wherein said vapor deposition is based on a metal-organic chemical vapor deposition method.

19. A semiconductor manufacturing method using the semiconductor manufacturing apparatus according to claim 14, the method comprising the step of regulating pressure on an upstream side of said element.

20. The semiconductor manufacturing method according to claim 19, further comprising the step of depositing a semiconductor film on said substrate by vapor deposition.

21. The semiconductor manufacturing method according to claim 20, further comprising the step of depositing a nitride compound semiconductor film on said substrate by vapor deposition.

22. The semiconductor manufacturing method according to claim 20, wherein said vapor deposition is based on a hydride vapor deposition method.

**23.** The semiconductor manufacturing method according to claim 20, wherein said vapor deposition is based on a metal-organic chemical vapor deposition method.

FIG.1

## FIG.2

## FIG.3

**FIG.4**

EP 1 870 490 A2

FIG.5

TO
EXHAUST
PORT

EP 1 870 490 A2

FIG.6

# FIG.7

(a)

33a 9

V31

33 33b 9

GAS → B 33c 9 37 TO EXHAUST PORT

33d 9

33e 9

31

(b)

V2 P2 F P3 T1 9

33a ∼ 33e

FIG.8

## FIG.9

(a)

(b)

FIG.10

V42

V41

43a

TO
EXHAUST
PORT

P41

F41

GAS →

43

41

TO
ATMOSPHERE

FIG.11

V41

45

GAS →

43

M41

41

TO
ATMOSPHERE

FIG.12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002313731 A
- JP 2000012900 A